# EUROPEAN PATENT APPLICATION

(11) **EP 1 575 088 A1**
(43) Date of publication of application: **14.09.2005**
(21) Application number: 03778868.4
(22) Date of filing: 12.12.2003
(51) Int. Cl.: H01L 23/02

(54) **MAGNETIC MEMORY DEVICE**

(30) Priority: 16.12.2002 JP 2002363199
(71) Applicant: SONY CORPORATION, Tokyo 141-0001 (JP)
(72) Inventor: KATO, Yoshihiro, Shinagawa-ku, Tokyo 141-0001 (JP); OKAYAMA, Katsumi, Shinagawa-ku, Tokyo 141-0001 (JP); KOBAYASHI, Kaoru, Shinagawa-ku, Tokyo 141-0001 (JP); YAMAMOTO, Tetsuya, Shinagawa-ku, Tokyo 141-0001 (JP); IKARASHI, Minoru, Shinagawa-ku, Tokyo 141-0001 (JP)
(74) Representative: Müller, Frithjof E.
(86) International application number: PCT/JP2003/015940
(87) International publication number: WO 2004/055888

(57) **Abstract**

A magnetic memory device in which an MRAM element is magnetically shielded from a large external magnetic field in an satisfactory manner, making it possible to surely achieve an operation free of problems in a magnetic field generated by the environment in which the MRAM element is used. A magnetic random access memory (MRAM) (30) is constituted by a TMR element (10) having a magnetized pinned layer (4), (6) with fixed direction of magnetization and a magnetic layer (memory layer) (2) with changeable direction of magnetization stacked on one another, mounted on a substrate together with another element (38), such as a DRAM , wherein a magnetic shielding layer (33), (34) is formed in a region corresponding to an area occupied by the MRAM element (30) or/and a magnetic shielding layer (33), (34) is with a distance of 15 mm or less between the opposite sides (especially, a length or a width).

## Description

### Technical Field

The present invention relates to a magnetic memory device constituted by a magnetic random access memory which includes a memory element including a magnetized pinned layer with fixed direction of magnetization and a magnetic layer with changeable direction of magnetization, the layers being stacked on one another in a so-called MRAM (magnetic random access memory) which is a so-called nonvolatile memory, or a magnetic memory device including a memory element having a magnetizable magnetic layer.

### Background Art

As a result of a dramatic popularization of information communication apparatuses, especially small machines for personal use such as portable terminals there is demand for increasingly higher performance for the memory and logic devices that constitute such apparatuses, such as demands for higher degree of integration, higher speed and lower power consumption.

Particularly, a nonvolatile memory is considered indispensable in a "ubiquitous era". Even when power supply depletion or failure occurs or disconnection of a server and a network occurs due to problems of any sort, a nonvolatile memory can protect important information including personal information. In addition, recent portable machines are designed so that a non-operating circuit block is maintained in a standby state to reduce the power consumption to a lowest level as possible, and the waste of power consumption and memory can be avoided if a nonvolatile memory capable of serving as both a high speed network memory and a large storage capacity memory can be realized. Further, when the high-speed large-capacity nonvolatile memory can be realized, an "instant-on" function such that a machine works the instance it is turned on may be realized.

Examples of nonvolatile memories include a flash memory using a semiconductor and an FRAM (ferroelectric random access memory) using a ferroelectric material.

However, flash memories have a disadvantage in that the write speed is as low as the order of microsecond. On the other hand, with respect to the FRAM, problems have been pointed out such that the number of allowable rewritings is 10¹² to 10¹⁴, which is not sufficient to completely replace the existing memory by an SRAM (static random access memory) or a DRAM (dynamic random access memory), and that micro-fabrication of a ferroelectric capacitor is difficult to realize.

A magnetic memory called MRAM described in Wang et al., IEEE Trans. Magn. 33 (1997), 4,498, for example, has been catching attention as a prospective nonvolatile memory which does not present the above-mentioned problems and which operates at high speed, having a large storage capacity (increased degree of integration) and lower power consumption, and, especially as the properties of TMR (tunnel magneto resistance) materials have improved.

The MRAM is a semiconductor magnetic memory utilizing a magnetoresistance effect based on the spin-dependent conduction phenomenon specific to nanomagnetic materials, and is a nonvolatile memory which can keep storage without supplying electric power from the outside.

In addition, the MRAM has a simple structure and is easy to increase the degree of integration, and it records data by utilizing rotation of a magnetic moment and therefore has higher endurance, and it is expected that the access time of MRAM is very fast, and it has already been reported in R. Scheuerlein et al, ISSCC Digest of Technical Papers, pp. 128-129, Feb. 2000 that the MRAM can be operated at 100 MHz. Recently, as reported in k. Inomata, Abstracts 18aA-1 of The 26th Annual Conference on Magnetics in Japan, and the like, the MRAM has been seen as a prospective main nonvolatile memory of a next generation.

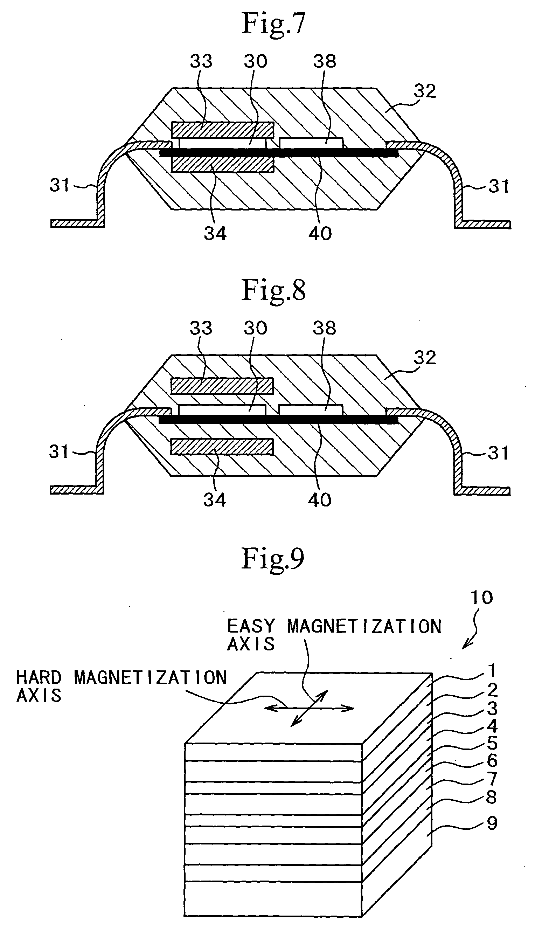

A further description of the MRAM is provided in FIG. 9, in which a TMR element 10 serving as a memory element of a memory cell of MRAM includes a storage layer 2 in which the magnetization relatively easily rotates, and magnetized pinned layers 4, 6, which are formed on a supporting substrate 9.

The magnetized pinned layer includes two magnetized pinned layers, i.e., a first magnetized pinned layer 4 and a second magnetized pinned layer 6, and between them is disposed a conductive layer 5 through which these magnetic layers are antiferromagnetically bound. In the storage layer 2 and magnetized pinned layers 4, 6, a ferromagnetic material included of nickel, iron, or cobalt, or an alloy thereof is used, and, as a material for the conductive layer 5, ruthenium, copper, chromium, gold, silver, or the like can be used. The second magnetized pinned layer 6 is in contact with an antiferromagnetic material layer 7, and the exchange interaction between these layers causes the second magnetized pinned layer 6 to have strong magnetic anisotropy in one direction. As a material for the antiferromagnetic material layer 7, a manganese alloy with iron, nickel, platinum, iridium, or rhodium, or cobalt or nickel oxide can be used.

A tunnel barrier layer 3 of an insulator including an oxide or nitride of aluminum, magnesium, silicon, or the like is disposed between the storage layer 2 and the first magnetized pinned layer 4 as magnetic layers, and breaks the magnetic binding between the storage layer 2 and the magnetized pinned layer 4 and permits a tunnel current to flow. The magnetic layers and conductive layers are formed mainly by a sputtering method, but the tunnel barrier layer 3 can be obtained by oxidizing or nitriding a metal film formed by sputtering. A topcoat layer 1 has roles in preventing mutual diffusion between the TMR element 10 and the wiring connected to the TMR element, lowering the contact resistance, and preventing oxidation of the storage layer 2, and, in general, a material, such as Cu, Ta, or TiN, can be used. An undercoat electrode layer 8 is used for connecting a switching element connected in series to the TMR element. The undercoat layer 8 may serve as the antiferromagnetic material layer 7.

In the thus constructed memory cell, a change of the tunnel current caused by a magnetoresistance effect is detected to read information as described below, and the effect depends on the relative direction of magnetization of the storage layer and the magnetized pinned layer.

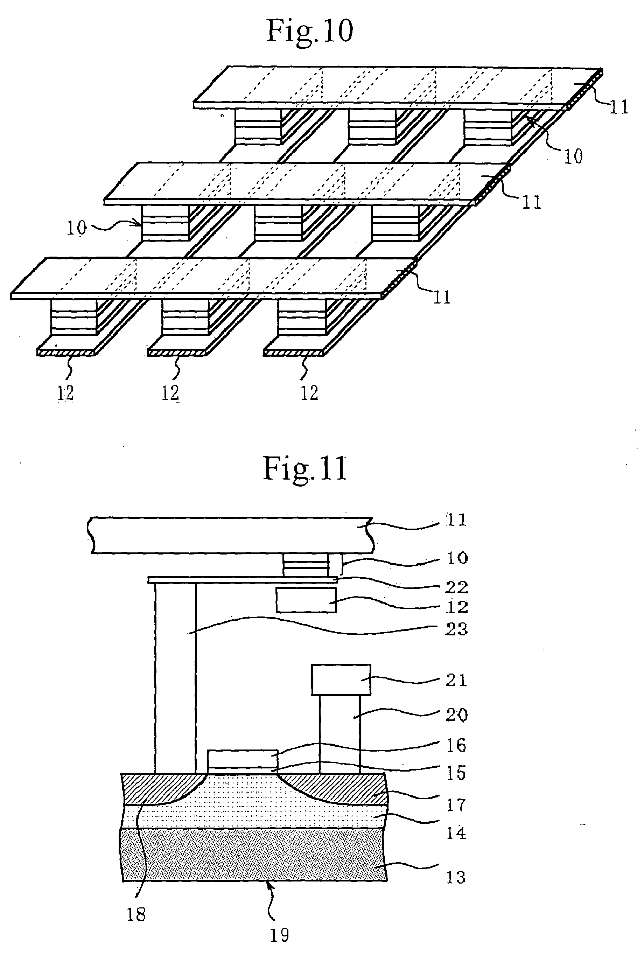

FIG. 10 is an enlarged perspective view diagrammatically showing part of a generic MRAM. Here, for simplification purposes, a read-out circuit portion is not shown, and, for example, the MRAM includes nine memory cells, and has bit lines 11 and word lines 12 for write, which cross one another. At each crossing point is disposed the TMR element 10, and, in writing on the TMR element 10, a current is permitted to flow the bit line 11 and word line 12 for write, and a composite magnetic field of the magnetic fields generated from the above lines changes the direction of magnetization of the storage layer 2 in the TMR element 10 at the crossing point of the bit line 11 and the word line 12 for write to be parallel or non-parallel to the magnetized pinned layer, thus achieving writing.

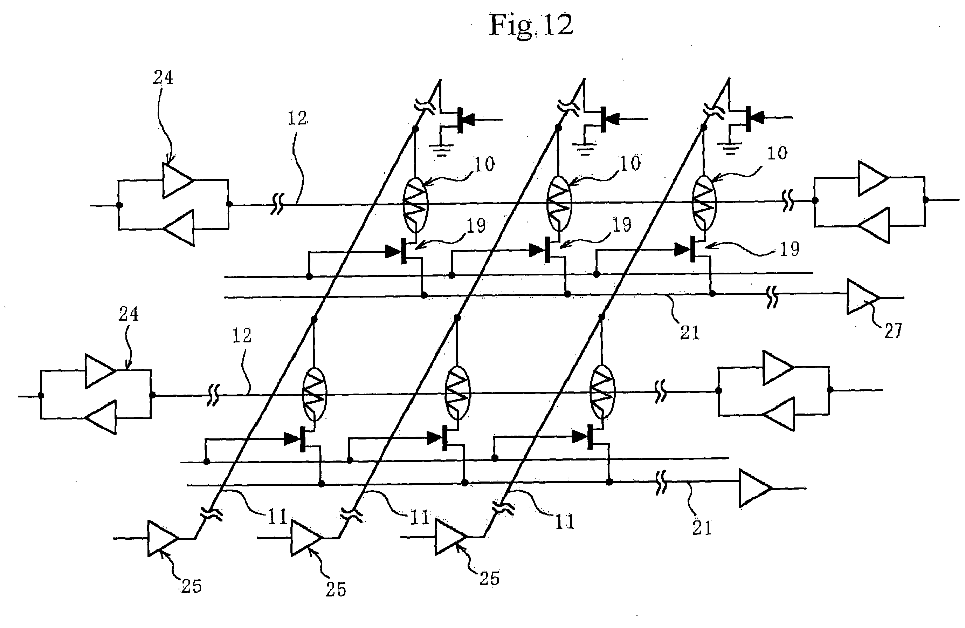

FIG. 11 diagrammatically shows a cross-sectional view of a memory cell, and, for example, an n-type field effect transistor 19 for read-out including a gate insulating film 15 formed in the p-type well region 14 formed in a p-type silicon semiconductor substrate 13, a gate electrode 16, a source region 17, and a drain region 18 is disposed, and the word line 12 for write, the TMR element 10, and the bit line 11 are disposed on the transistor. To the source region 17 is connected a sense line 21 through a source electrode 20. The field effect transistor 19 serves as a switching element for read-out, and a wiring 22 for read-out drawn from a portion between the word line 12 and the TMR element 10 is connected to the drain region 18 through a drain electrode 23. The transistor 19 may be an n-type or p-type field effect transistor, but, instead of the transistor, various switching elements, such as a diode, a bipolar transistor, and a MESFET (metal semiconductor field effect transistor), can be used.

FIG. 12 is an equivalent circuit diagram of an MRAM, which, for example, includes six memory cells, and has bit lines 11 and word lines 12 for write, which cross one another, and, at the crossing point of these write lines, it has a TMR element 10, and a field effect transistor 19 and a sense line 21 which are connected to the TMR element 10 to select an element upon reading-out. The sense line 21 is connected to a sense amplifier 27 to detect information stored. In the figure, numeral 24 designates a word line current driving circuit for bidirectional write, and numeral 25 designates a bit line current driving circuit.

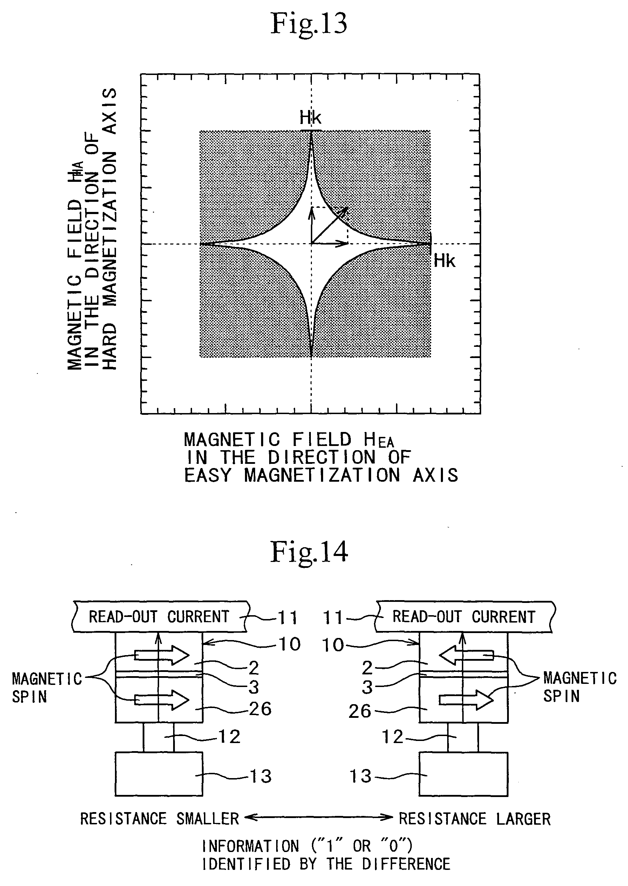

FIG. 13 shows an asteroid curve representing the write conditions of MRAM, and indicates a threshold for inversion of the direction of magnetization of the storage layer by the applied magnetic field H_{EA} in the direction of easy magnetization axis and magnetic field H_{HA} in the direction of hard magnetization axis. When a composite magnetic field vector corresponding to the outside of the asteroid curve is generated, magnetic field inversion is caused, but a composite magnetic field vector of inside of the asteroid curve cannot cause inversion of the cell in one current stable state. In addition, in the cell not at the crossing point of the word line and the bit line through which a current flows, a magnetic field generated solely by the word line or bit line is applied and, when the magnetic field generated is equal to or higher than the inversion magnetic field H_{K} in one direction, the direction of magnetization of the cell not at the crossing point is inverted, and therefore, the element is set so that selective writing on the selected cell is possible only when the composite magnetic field falls within the gray region in the figure.

As described above, in the MRAM, using two write lines, i.e., a bit line and a word line and utilizing the asteroid magnetization inversion properties, writing is in general conducted only on a selected memory cell by inversion of the magnetic spin. The composite magnetization in a single storage region is determined by synthesizing vectors of the magnetic field H_{EA} in the direction of easy magnetization axis and the magnetic field H_{HA} in the direction of hard magnetization axis applied to the storage region. The write current applied to the bit line applies to the cell the magnetic field H_{EA} in the direction of easy magnetization axis, and the current applied to the word line applies to the cell the magnetic field H_{HA} in the direction of hard magnetization axis.

FIG. 14 illustrates the read-out operation of an MRAM. Here, the layer construction of the TMR element 10 is diagrammatically shown, and the above-mentioned magnetized pinned layer is indicated as a single layer 26, and the layers are not shown, excluding the storage layer 2 and the tunnel barrier layer 3.

In other words, as mentioned above, in writing of information, the magnetic spin of the cell is inverted by the composite magnetic field at the crossing point of the bit line 11 and the word line 12 disposed in a matrix form to record information of "1" or "0" according to the direction of the magnetic spin. On the other hand, read-out is achieved utilizing a TMR effect which is an applied form of the magnetoresistance effect, wherein the TMR effect is a phenomenon in which the resistance changes depending on the direction of the magnetic spin, and information of "1" or "0" is detected according to the state of high resistance in which the magnetic spin is non-parallel or the state of low resistance in which the magnetic spin is parallel. The read-out is conducted by permitting a read-out current (tunnel current) between the word line 12 and the bit line 11 and reading the output according the high or low resistance by the sense line 21 through the field effect transistor 19 for read-out.

As mentioned above, the MRAM has been seen as a prospective a high-speed nonvolatile memory having a large capacity, but it uses a magnetic material in keeping storage and hence poses a problem in that the MRAM is likely to suffer erasing or rewriting of the stored information due to an external magnetic field. The reason for this resides in that the inversion magnetic field in the direction of easy magnetization axis and the inversion magnetic field H_{SW} in the direction of hard magnetization axis described above with reference to FIG. 13, although vary depending on the material, are as small as 20 to 200 oersteds (Oe), which corresponds to a current of several mA {see R. H. Koch et al., Phys. Rev. Lett. 84, 5419 (2000), J. Z. Sun et al., 2001 8^{th} Joint Magnetism and Magnetic Material}. In addition, the coercive force (Hc) upon writing is, for example, several to about 10 Oe, and an external magnetic field higher than that value causes an internal leakage magnetic field in the MRAM, so that selective writing on a predetermined memory cell may be impossible.

As a result, prevention of external magnetic interaction, i.e., the establishment of a magnetic shielding structure for shielding an element from an external electromagnetic wave is desired as a step for putting the MRAM into practical use.

Environments in which the MRAM is mounted and used are mainly on a high-density printed circuit board and in an electronic apparatus. Although varying depending on the types of electronic apparatuses, with the recent developments in the high-density mounting techniques, a semiconductor element, an element for communication, a micro scaled motor, and the like are mounted with high density on a high-density printed circuit board and, in an electronic apparatus, an antenna element and a variety of mechanical parts, a power source, and the like are mounted with high density to constitute a single apparatus.

Although the fact that the MRAM and other elements can be mounted together as mentioned above being one of the features of the MRAM as a nonvolatile memory, an environment is made in which a direct current and magnetic field components in wide frequencies ranging from a low frequency to a high frequency are present around the MRAM, and therefore, for securing the reliability of keeping the recorded data on the MRAM, the improvement of a method for mounting the MRAM itself or a shielding structure to enhance the resistance to an external magnetic field is desired.

With respect to the external magnetic field, magnetic cards such as credit cards and cash cards for banks are specified to have a resistance to a magnetic field of 500 to 600 Oe. Therefore, in the field of magnetic card, a magnetic material having a large coercive force, such as Co-coated γ-Fe₂O₃ or Ba ferrite, is used for dealing with that. Further, in the field of prepaid card, the card must have a resistance to a magnetic field of 350 to 600 Oe. The MRAM element is a device which is mounted in a housing for electronic apparatus and presumed to be moved, and hence is needed to have a resistance to a strong external magnetic field equivalent to that of the magnetic cards, and, especially for the above-mentioned reason, it is required to suppress the internal (leakage) magnetic field to as small as 20 Oe or less, desirably 10 Oe or less.

As a magnetic shielding structure for MRAM, a method in which an insulating ferrite (MnZn and NiZn ferrite) layer is used in a passivation film for an MRAM element to provide magnetic shielding properties has been proposed {see U.S. Patent No. 5,902,690, specification and drawings (column 5, and FIG.1 and FIG.3)}. In addition, a method in which a magnetic material having high magnetic permeability, such as Permalloy, is put on the top and bottom of a package so that the package has a magnetic shielding effect to prevent magnetic flux from penetrating an internal element has been proposed {see U.S. Patent No. 5,939,772, specification and drawings (column 2, and Fig. 1 and Fig. 2)}. Further, a structure such that an element is covered with a shield lid included of a magnetic material, such as soft iron, is disclosed {see Unexamined Japanese Patent Application Laid-Open Specification No. 2001-250206 (page 5, right-hand column, Fig. 6)} .

For preventing external magnetic flux from penetrating a memory cell of an MRAM, it is most important that a magnetic material having high magnetic permeability is arranged around the element to create a magnetic path which inhibits the magnetic flux from penetrating the inside of the element.

However, when the passivation film for the element is formed from ferrite as proposed in U.S. Patent No. 5, 902, 690, the ferrite itself has a low saturation magnetization {general ferrite material: 0.2 to 0.5 tesla (T)} and hence cannot completely prevent external magnetic field from penetrating the element. With respect to the saturation magnetization of ferrite itself, NiZn ferrite and MnZn ferrite have saturation magnetization as low as 0.2 to 0.35 T and 0.35 to 0. 47 T, respectively, and the external magnetic field penetrating the MRAM element is as large as several hundred Oe, and therefore that saturation magnetization of the ferrite causes the magnetic permeability to be approximately 1 due to magnetic saturation of the ferrite, so that the element cannot function. There is no description of the thickness in U. S. Patent No. 5, 902, 690, but, in general, the passivation film has a thickness of about 0.1 µm at most, which is too small for the magnetic shielding layer, and thus the effect cannot be expected from this film. In addition, when ferrite which is an oxide magnetic material is used in the passivation film, oxygen defect is likely to occur during the deposition of the film by a sputtering method, making it difficult to use complete ferrite as the passivation film.

In U.S. Patent No. 5,939,772, a structure in which the top and bottom of a package are covered with Permalloy layers is described, and the use of Permalloy can achieve shielding performance higher than that obtained by the ferrite passivation film. However, the mu metal disclosed in U.S. Patent No. 5,939,772 has a magnetic permeability µi as extremely high as about 100,000, but it has a saturation magnetization as low as 0.7 to 0.8 T and is easily saturated in an external magnetic field to cause the magnetic permeability µ to be 1. Thus, there is a disadvantage in that the thickness of the shielding layer must be considerably increased for obtaining perfect magnetic shielding effect. Therefore, as a matter of fact, as the magnetic shielding layer structure for preventing a magnetic field of several hundred Oe from penetrating the element, the structure disclosed is incomplete for both the reasons of too small saturation magnetization of the Permalloy and too small thickness of the layer.

In Unexamined Japanese Patent Application Laid-Open Specification No. 2001-250206, a magnetic shielding structure using soft iron or the like is disclosed. This structure merely covers the top of the element and hence the magnetic shielding is incomplete, and further, the soft iron has a saturation magnetization of 1.7 T and a magnetic permeability µi of about 300 and thus, the magnetic properties are unsatisfactory. Therefore, when performing magnetic shielding using the structure described in Unexamined Japanese Patent Application Laid-Open Specification No. 2001-250206, it is considerably difficult to completely prevent an external magnetic field from penetrating the element.

The present invention has been conceived in view of the above, and an obj ect thereof is to magnetically shield an MRAM element from a large external magnetic field in a satisfactory manner, making it possible to surely achieve operation free of problems in a magnetic field generated by the environment in which the MRAM element is used.

### DISCLOSURE OF THE INVENTION

Specifically, the present invention is directed to a magnetic memory device including a magnetic random access memory (MRAM) which includes a memory element, and which is mounted on a substrate, together with another element, wherein the memory element includes a magnetized pinned layer in which the direction of magnetization is fixed, and a magnetic layer in which the direction of magnetization is changeable, which layers are stacked on one another, or a magnetic memory device including a memory element which has a magnetizable magnetic layer, and which is mounted on a substrate, together with another element, wherein the magnetic memory device is characterized in that a magnetic shielding layer for magnetically shielding the memory element is formed in a region corresponding to an area occupied by the memory element (hereinafter, this magnetic memory device is referred to as "the first magnetic memory device of the present invention").

In addition, the present invention provides a magnetic memory device constituted as a magnetic random access memory which includes a memory element including a magnetized pinned layer in which the direction of magnetization is fixed and a magnetic layer in which the direction of magnetization is changeable, which layers are stacked on one another, or a magnetic memory device including a memory element having a magnetizable magnetic layer, wherein the magnetic memory device is characterized in that a magnetic shielding layer for magnetically shielding the memory element is formed so that a distance between the opposite sides of the magnetic shielding layer is 15 mm or less (especially, a length or a width is 15 mm or less)(hereinafter, this magnetic memory device is referred to as "the second magnetic memory device of the present invention").

The inventors of the present invention have conducted studies on the magnetic shielding for a memory element in a magnetic memory device, such as an MRAM, and had the following understanding. The magnetic shielding effect is attenuated as magnetic saturation of the magnetic material constituting the magnetic shielding layer proceeds, and the magnetization saturation of the magnetic shielding layer having a plate form or the like is first caused at a portion in which the demagnetizing field is minimum, that is, portion farthest from the edge portion, and therefore, when a magnetic shielding layer is formed in a package, the shielding effect at the center portion of the package is weakest.

However, neither description concerning the size of the package nor description concerning the size of the magnetic shielding layer is found in any conventional techniques mentioned above. In general, in magnetic shielding, it is essential that the magnetic shielding material is not magnetically saturated in an external magnetic field, but a magnetic material having a small coercive force (i.e., small anisotropic magnetic field), such as an Fe-Ni soft magnetic alloy, easily undergoes magnetic saturation in a slight magnetic field, and hence it is not suitable for shielding the large external magnetic field in the MRAM element. Especially when the magnetic shielding layer has a larger area, the magnetic moment of the magnetic shielding layer itself at the center portion of the magnetic shielding layer is easily in-plane oriented due to the form anisotropy and hence the shielding effect is actually lowered, and therefore careful consideration of the shield area is needed.

In addition, the inventors have made extensive and intensive studies based on such understanding. As a result, it has been found that, in the magnetic memory device, especially in the MRAM, in which a memory element is mounted on a substrate, together with another element, such as a DRAM, when a magnetic shielding layer for magnetically shielding the memory element is formed in a region corresponding to an area occupied by the memory element, the size of the magnetic shielding layer can be reduced to as small as the area occupied by the memory element to shorten the distance from the edge portion to the center portion of the magnetic shielding layer, so that magnetic saturation at the center portion is satisfactorily suppressed to improve the magnetic shielding effect, thus making it possible to surely achieve operation of the magnetic memory device, and the first magnetic memory device of the present invention has been achieved.

Further, it has been found that, in the magnetic memory device, especially in the MRAM, when a distance between the opposite sides (especially a length or a width) of the magnetic shielding layer for magnetically shielding the memory element is 15 mm or less, the distance from the edge portion to the center portion of the magnetic shielding layer can be shortened, so that magnetic saturation at the center portion is satisfactorily suppressed to improve the magnetic shielding effect, thus making it possible to surely achieve operation of the magnetic memory device, and the second magnetic memory device of the present invention has been completed.

In addition, with respect to the magnetic shielding layer, the size may be the same as a region corresponding to an area occupied by the MRAM element, and the size may be either larger or smaller slightly than the region as long as it is substantially the same as the region, and the size or form may be changed depending on the size or form of the MRAM element. The distance between the opposite sides means a distance between two sides parallel to each other (or not parallel but opposite to each other), for example, a length of one side of a square, or a length of a longer side of a rectangle.

### BRIEF DESCRIPTION OF THE DRAWINGS

FIGs. 1A to 1B are a diagrammatic cross-sectional view and a detailed plan view of an MRAM mounted package according to one embodiment of the present invention.
FIG. 2 is a diagrammatic cross-sectional view of another MRAM mounted package according to the embodiment.
FIG. 3 is a diagrammatic cross-sectional view of another MRAM mounted package according to the embodiment.
FIGs. 4A and 4B are a diagrammatic cross-sectional view for explaining the measurement of an intensity of an internal magnetic field between the magnetic shielding layers, and a diagrammatic cross-sectional view of a sample package in the embodiment.
FIG. 5 is a graph showing the distribution of magnetic field intensity inside a QFP160PIN package having magnetic shielding layers (Permalloy plates) disposed on the top and bottom of the package in the embodiment.
FIG. 6 is a graph showing the distribution of magnetic field intensity obtained by plotting the internal magnetic field of the package having magnetic shielding layers disposed on both the top and bottom of the package in the embodiment, taking a distance from the end of the package as the abscissa.
FIG. 7 is a diagrammatic cross-sectional view of another MRAM mounted package according to one embodiment of the present invention.
FIG. 8 is a diagrammatic cross-sectional view of still another MRAM mounted package according to the embodiment.
FIG. 9 is a diagrammatic perspective view of a TMR element of an MRAM.
FIG. 10 is a diagrammatic perspective view of part of a memory cell portion of an MRAM.
FIG. 11 is a diagrammatic cross-sectional view of a memory cell of an MRAM.
FIG. 12 is an equivalent circuit diagram of an MRAM.
FIG. 13 is a diagram showing the magnetic field response properties upon writing on an MRAM.
FIG. 14 is a diagram showing the principle of read-out operation of an MRAM.

### BEST MODES FOR CARRYING OUT THE INVENTION

In the first and second magnetic memory devices of the present invention, for effectively exhibiting a magnetic shielding effect, it is preferred that the magnetic shielding layer is disposed on the top portion and/or bottom portion of a package of the memory element, or/and in a package of the memory element at the upper portion and/or lower portion as viewed from the memory element.

It is preferred that the magnetic shielding layer is constituted by a soft magnetic material which includes a soft magnetic material having high saturation magnetization and high magnetic permeability and containing at least one member selected from Fe, Co, and Ni, for example, a soft magnetic material having high saturation magnetization and high magnetic permeability, such as Fe, FeCo, FeCoV, FeNi, FeSiAl, FeSiB, or FeAl.

In the second magnetic memory device of the present invention, when the memory element is mounted on a substrate, together with another element, such as a DRAM, it is especially desired that the magnetic shielding layer is formed in a region corresponding to an area occupied by the memory element so that a distance between the opposite sides of the magnetic shielding layer is 15 mm or less.

The present invention is preferred as an MRAM, and the MRAM is preferably constituted so that the magnetized pinned layer and the magnetic layer have disposed therebetween an insulating layer or a conductive layer, and the magnetic layer is magnetized in a predetermined direction by means of a magnetic field induced by allowing a current to flow individually wirings formed as a bit line and a word line on the top surface and bottom surface of the memory element to write information and the written information is read by a tunnel magnetoresistance effect (TMR effect) between the wirings.

Hereinbelow, preferred embodiments of the present invention will be described in detail with reference to the drawings.

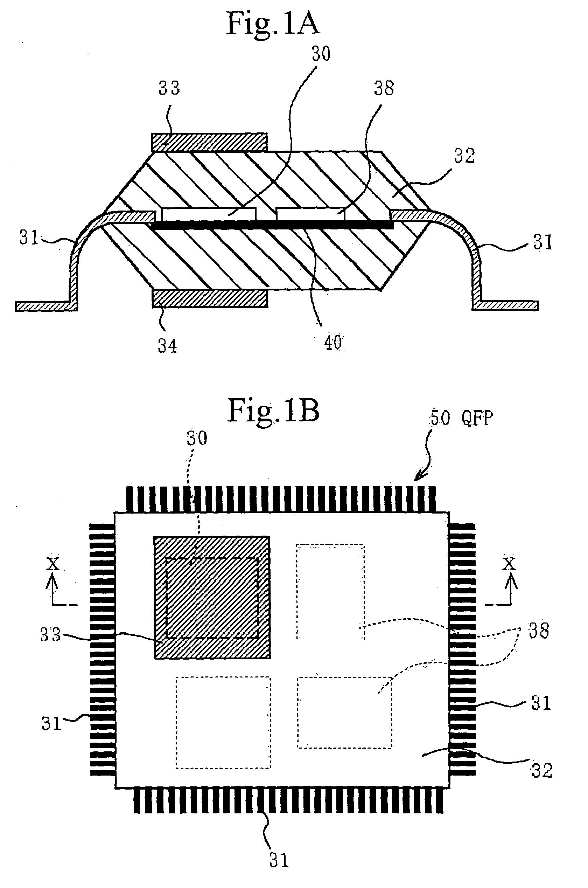

FIGs. 1A to 3 illustrate examples of packages having mounted thereon an MRAM element and another element (MRAM element mounted packages), and having various magnetic shielding structures according to the present embodiment.

In these examples, an MRAM element (chip including a memory cell portion and a peripheral circuit portion) 30 shown in FIGs. 9 to 11 and another element 38, such as a DRAM, an MPU (micro processing unit), a DSP (digital signal processor), or an RF (radio frequency) element, are formed on a die pad 40, and sealed by a sealer 32, such as a mold resin (e.g., an epoxy resin), excluding an external lead 31 connected to a printed circuit board (not shown). (Here the MRAM element 30 has the same structure and operation principle as those of the above-described MRAM and the descriptions therefor are omitted and the lead frame including the die pad 40 is shown in a simplified manner).

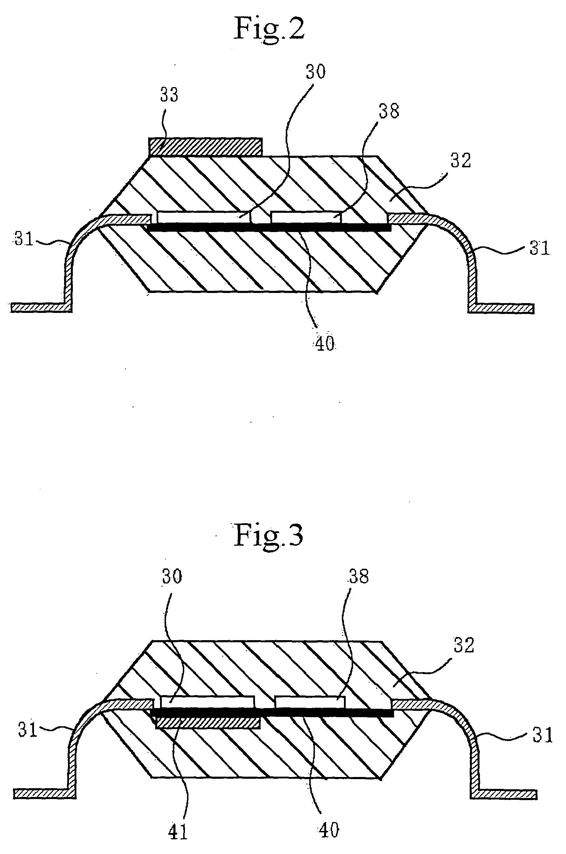

An example (FIGs. 1A and 1B: FIG. 1A is a cross-sectional view taken along the X-X line in FIG. 1B) in which, according to the present invention, magnetic shielding layers 33, 34 constituted by Permalloy (FeNi) or the like are formed in regions corresponding to an area occupied by the MRAM element 30 so that the layers are in contact with, respectively, the top surface and bottom surface of the sealer 32, an example (FIG. 2) in which only the magnetic shielding layer 33 is formed on the top surface of the sealer 32, and an example (FIG. 3) in which a magnetic shielding layer 41 is disposed on the bottom surface of the die pad 40 on the side opposite to the MRAM element 30 in the sealer 32 are shown.

The magnetic shielding layers 33, 34 may be bonded onto the sealer 32 after sealing by the sealer 32, or be preliminarily bonded to the bottom of the die pad 40 upon sealing or placed in a die. In FIGs. 1A and 1B, the package has a sandwich structure including the MRAM element 30 disposed between the magnetic shielding layers 33, 34, and, considering mounting on a printed circuit board (circuit board); all of the above structures are desired structures such that the magnetic shielding layer is unified with the package of MRAM.

In each of the magnetic shielding structures shown in FIGs . 1A to 3, the magnetic shielding layers 33, 34 are formed substantially only in a region corresponding to an area occupied by the MRAM element 30, and therefore the magnetic shielding layer can be reduced in size to as small as 15 mm or less, and magnetic saturation due to an external magnetic field is unlikely to be caused at the center portion of the magnetic shielding layer, so that the magnetic shielding layer has an effect to satisfactorily magnetically shield the MRAM element 30 from an external applied magnetic field. In this case, the magnetic shielding layers 33, 34 do not form a closed magnetic circuit between the layers and the outside, but they can effectively collect an external applied magnetic field to achieve magnetic shielding. The magnetic shielding layers 33, 34 are preferably present, respectively, on the upper portion and lower portion of the MRAM element 30, but even one magnetic shielding layer present on at least one of the upper and lower portions exhibits the shielding effect.

The MRAM element 30 is in general encapsulated with a resin in a package such as, a QFP (quad flat package) or a SOP (small outline package), and then mounted on a substrate and practically used. The size of the MRAM element is substantially specified by the number of pins and, for example, an element having 48 pins is called QFP-48PIN. The MRAM element is a nonvolatile memory element and requires a package having a larger number of pins, and, in the MRAM element having a storage capacity as large as 1 Mbit, a QFP160PIN or QFP208PIN package must be used as a package. In FIG. 1B, for example, a QFP160PIN package 50 is shown.

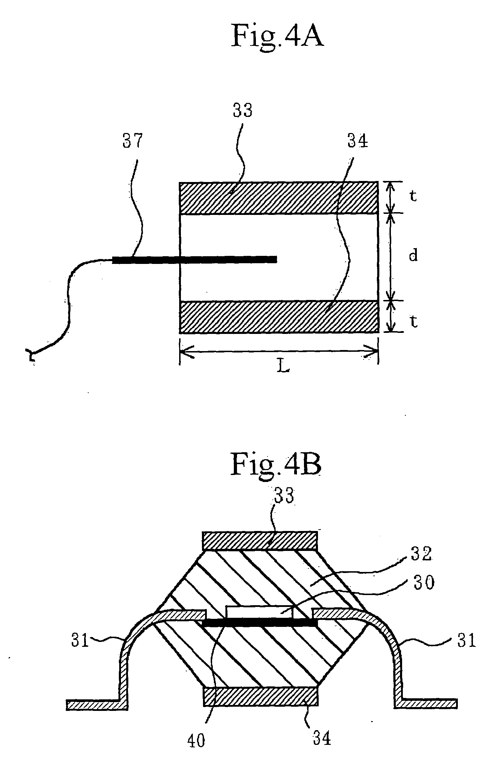

For demonstrating that normal operation of the MRAM element can be surely achieved, the present inventors have made an experiment for the purpose of obtaining performance such that, even when a direct external magnetic field as large as up to 50 Oe is applied, the internal magnetic field (at the MRAM element portion) is reduced to as small as 20 Oe or less, desirably 10 Oe or less. FIG. 4A is a diagrammatic view showing the experiment, and, for example, two magnetic shielding layers 33, 34 constituted by Permalloy having a length of L28 mm-L28 mm and a thickness t of 200 µm were disposed at a distance d of 3.45 mm and a gauss meter 37 was placed at the center portion (hollow portion), and then a direct magnetic field of 500 Oe was applied in parallel with the magnetic shielding layer and the gauss meter 37 was moved in parallel with the magnetic shielding layer to measure an intensity of an internal magnetic field from the end to the center portion (intensity of a leakage magnetic field from the magnetic shielding layer), so that studies were made on the effective magnetic shielding material.

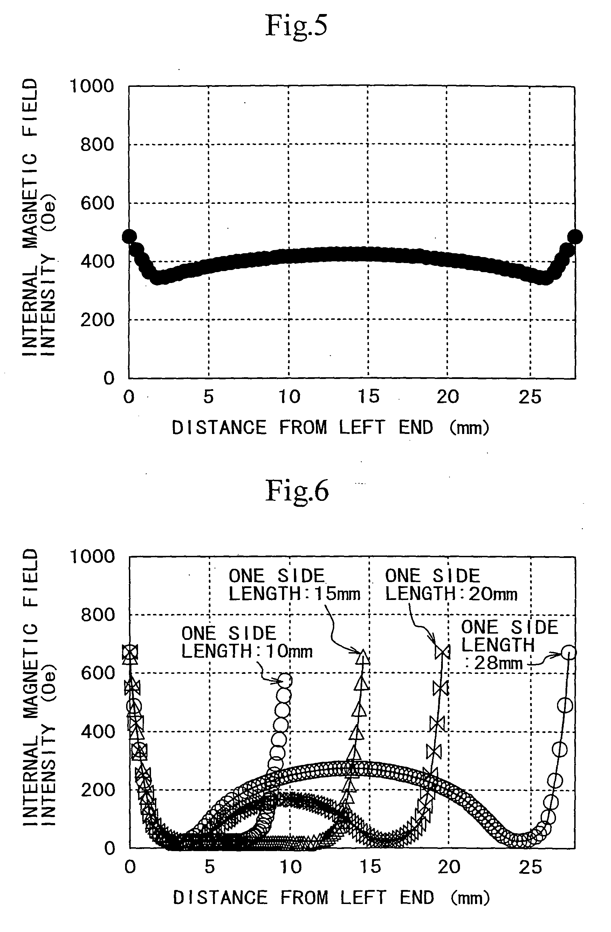

FIG. 5 shows the results of the measurement by the method shown in FIG. 4A, which correspond to the distribution of the magnetic field intensity inside the package having a structure in which Permalloy plates are disposed on the top and bottom of a QFP160PIN package having a length of 28 mm-28 mm and a thickness of 3.45 mm. Specifically, the external applied magnetic field intensity is 500 Oe, and, as shown in FIG. 4B, the QFP160PIN package has one side of about 28 mm and a thickness of 3.45 mm, and only an MRAM element 30' is disposed at the center portion of the package.

As apparent from FIG. 5, a magnetic field intensity at the end of the magnetic shielding layer is about 500 Oe, and an intensity of an internal magnetic field at a portion about 1.5 mm inside from the end of the magnetic shielding layer is about 370 Oe. However, an intensity of an internal magnetic field at a further inner portion is not smaller and is as large as 370 to 400 Oe. This magnetic field intensity exceeds the intensity which adversely affects the storage operation of the MRAM element 30', which indicates that the layer does not function as a magnetic shield. The reason for this resides in that the magnetic moment at the center portion of the magnetic shielding layer is in-plane oriented due to the form anisotropy even when no external magnetic field is applied, and hence the layer cannot serve as a magnetic shield.

In general, for surely achieving storage operation of the MRAM, it is required that the magnetic field intensity at at least the MRAM element portion be reduced to 20 Oe or less, desirably 10 Oe or less.

In view of that, the present inventors have made detailed study on the length of one side of the magnetic shielding layer which undergoes no magnetic saturation. FIG. 6 shows the results of the measurement by the method shown in FIG. 4A of an internal magnetic field of a package having magnetic shielding layers formed on both the top and bottom surfaces, and plotting points on the graph taking a distance from the end of the package as the abscissa. As the magnetic shielding material, FeCoV having a saturation magnetization Ms of 2. 3 T and an initial magnetic permeability µi of 1,000 was used, and the thickness of the magnetic shielding layer was 200 µm. The measurement was conducted at an external applied magnetic field intensity of 500 Oe with respect to four types of samples in which one side lengths of the magnetic shielding layers were 10 mm, 15 mm, 20 mm, and 28 mm.

As it can be seen from the results shown in FIG. 6, when the one side is 20 mm or 28 mm, magnetic saturation occurs at the inner portion of the layer and hence the magnetic field intensity at the center portion becomes larger. In contrast, when the one side is 15 mm or 10 mm, the magnetic field intensity at the center portion is remarkably reduced to 20 Oe or less, desirably 10 Oe or less. Therefore, when FeCoV is used as the magnetic shielding layer, for shielding a magnetic field at an intensity as high as 500 Oe or more, it is necessary that the one side (or the distance between the opposite sides) of the magnetic shielding layer be 15 mm or less. When the one side of the magnetic shielding layer is too small, the magnetic shielding effect is rather poor, and therefore, considering the size of the MRAM element, the one side (or the distance between the opposite sides) of the magnetic shielding layer is advantageously 3 mm or more, further advantageously 5 mm or more.

The MRAM element even at a 1-Mbit class in general has a several-mm square size, and hence, when the magnetic shielding layer has one side of 10 mm, the effective magnetic shielding region has a size such that one side is about 8 mm, which indicates that the magnetic shielding layer achieves magnetic shielding without any problem. Therefore, the structure which covers almost all the package shown in the above-mentioned U. S. Patent No. 5, 939, 772 lowers the magnetic shielding performance, but, when the magnetic shielding layer is formed substantially only in a region corresponding to an area occupied by the MRAM element 30 according to the present invention, the magnetic shielding layer has a size such that one side is 15 mm or less, desirably 10 mm or less, so that magnetic saturation of the magnetic shielding layer is effectively suppressed, thus making it possible to remarkably improve the magnetic shielding effect.

Particularly, as shown in FIGs . 1A and 1B in which the MRAM element 30 is mounted, together with the another element 38, e.g., a DRAM, the MRAM element is frequently mounted and used together with another IC rather than solely used, and, as apparent from the above results, in the MRAM element mounted package, when the magnetic shielding layers 33, 34 are formed substantially only in a region corresponding to an area occupied by the MRAM element 30 according to the present invention, the magnetic shielding effect is remarkably improved. (This is similar to the examples shown in FIGs. 2 and 3 and the other examples described below.)

From the above description, as shown in FIG. 6, when the magnetic shielding layer has a one side length of 15 mm or less, a magnetic shielding effect is expected by using the shielding material having a thickness of 200 µm, and, when the magnetic shielding layer has one side of 10 mm, the similar effect is expected by using the magnetic shielding layer having a thickness of about 150 µm.

In this way, it has been found that the magnetic shielding for MRAM element has an effective shielding range determined by the properties, thickness, and one side length of the magnetic material, and that, in the shielding structure in which the magnetic shielding layer constituted by, for example, a FeCoV alloy has a thickness of 200 µm, the MRAM element is required to be mounted with high density in a space having a one side length of 10 mm.

In addition, the MRAM element may be used solely, but it is frequently used, together with an MPU, a DSP, an RF element, or the like, as an MRAM mounted element in one package, and mounted in the form of a multi chip module or SIP (system in package) . In this case, considering the several-mm square area occupied by the MRAM element, when the magnetic shielding layer is not disposed on the entire surface of the top and bottom portions of the package but disposed at the upper and lower portions of the package in a region corresponding to an area occupied by the MRAM element 30 as shown in FIGs. 1A to 3, the one side and area of the magnetic shielding layer can be reduced, so that desirable magnetic shielding effect can be obtained. Further, this structure can considerably lower the cost for the material for magnetic shielding, realizing reduction of the production cost.

The magnetic shielding structure in the present invention realizes desirable magnetic shielding for MRAM by using a magnetic shielding layer having a smaller area and appropriately selecting the position of the magnetic shielding layer formed. Therefore, in the present invention, the magnetic shielding effect can be obtained not only in the structures shown in FIGs. 1A to 3 but also in, for example, a magnetic shielding structure in which the magnetic shielding layer is disposed only on the bottom portion of the package, and further a structure in which, as shown in FIG. 7, the magnetic shielding layers 33, 34 are disposed on the top surface of the MRAM element 30 and/or the bottom surface of the die pad 40 in the package so that the layers are in contact with the respective surfaces, and a structure in which, as shown in FIG. 8, the magnetic shielding layers 33, 34 are disposed in the package at the upper portion and/or lower portion as viewed from the MRAM element 30 so that the layers are not in contact with the MRAM element.

The embodiments described above can be changed or modified based on the technical concept of the present invention.

For example, the composition and type of the above magnetic shielding material, the thickness and arrangement of the magnetic shielding layer, the structure of the MRAM, and the like can be variously changed. The size of the magnetic shielding layer may be the same or substantially the same as a region corresponding to an area occupied by the MRAM element, and, when the size of the magnetic shielding layer is substantially the same as the region, the magnetic shielding layer may be either larger or smaller slightly than the MRAM element, and the magnetic shielding layer may be variously changed as long as it has one side of 15 mm or less. The magnetic shielding layer may be disposed either on both the top portion and the bottom portion of the MRAM element or package, or in the package at the upper portion and/or lower portion as viewed from the MRAM element, or/and on the top portion and/or bottom portion of the package of the MRAM element.

In addition, the present invention is preferred as an MRAM, but can be applied to another magnetic memory device including a memory element having a magnetizable layer.

In the present invention, as mentioned above, in the magnetic memory device, especially in the MRAM, when the memory element is mounted on a substrate, together with another element, such as a DRAM, the magnetic shielding layer for magnetically shielding the memory element is formed in a region corresponding to an area occupied by the memory element, and therefore the size of the magnetic shielding layer can be reduced to as small as the area occupied by the memory element to shorten the distance from the edge portion to the center portion of the magnetic shielding layer, so that magnetic saturation at the center portion is satisfactorily suppressed to improve the magnetic shielding effect, thus making it possible to surely achieve operation of the magnetic memory device.

Further, the distance between the opposite sides (especially, the length or width) of the magnetic shielding layer is 15 mm or less, and therefore the distance from the edge portion to the center portion of the magnetic shielding layer can be shortened, so that magnetic saturation at the center portion is satisfactorily suppressed to improve the magnetic shielding effect, thus making it possible to surely achieve operation of the magnetic memory device.

## Claims

1. A magnetic memory device comprising a magnetic random access memory including a memory element having a magnetized pinned layer with fixed direction of magnetization and a magnetic layer with changeable direction of magnetization stacked on one another, the magnetic random access memory mounted on a substrate together with another element, the magnetic memory device **characterized in that** a magnetic shielding layer for magnetically shielding the memory element is provided within a region corresponding to an area occupied by the memory element.

2. A magnetic memory device comprising a memory element including a magnetizable magnetic layer mounted on a substrate together with another element, the magnetic memory device **characterized in that** a magnetic shielding layer for magnetically shielding the memory element is provided in a region corresponding to an area occupied by the memory element.

3. A magnetic memory device comprising a magnetic random access memory including a memory element having a magnetized pinned layer with fixed direction of magnetization and a magnetic layer with changeable direction of magnetization stacked on one another, the magnetic memory device **characterized in that** a magnetic shielding layer for magnetically shielding the memory element is provided with a distance of 15 mm or less between opposite sides of the magnetic shielding layer.

4. A magnetic memory device comprising a memory element having a magnetizable magnetic layer, the magnetic memory device **characterized in that** a magnetic shielding layer for magnetically shielding the memory element is provided with a distance of 15 mm or less between opposite sides of the magnetic shielding layer.

5. The magnetic memory device according to claim 3 or 4, wherein the memory element is mounted on a substrate together with another element, and the magnetic shielding layer is provided within a region corresponding to an area occupied by the memory element.

6. The magnetic memory device according to any of claims 1 to 4, wherein the magnetic shielding layer is disposed on a top and/or bottom portion of a package of the memory element, or/and on an upper and/or lower portion within a package of the memory element.

7. The magnetic memory device according to any of claims 1 to 4, wherein a soft magnetic material forming the magnetic shielding layer comprises a soft magnetic material having high saturation magnetization and high magnetic permeability containing at least one member among Fe, Co, and Ni.

8. The magnetic memory device according to claim 1 or 3, constituted so that an insulating layer or a conductive layer are interposed between the magnetized pinned layer and the magnetic layer, information is written in by magnetizing the magnetic layer in a predetermined direction by means of a magnetic field induced by applying electrical current to wirings formed on a top and bottom surface of the memory element, and the written information is read out by a tunnel magnetoresistance effect existing between the wirings.
